# EUROPEAN PATENT APPLICATION

(11) **EP 2 922 101 A1**
(43) Date of publication of application: **23.09.2015**
(21) Application number: 14001007.5
(22) Date of filing: 19.03.2014
(51) Int. Cl.: H01L 31/18, H01L 31/0747, H01L 31/0224, H01L 31/068, H01L 31/0236

(54) **Conductive polymer/Si interfaces at the backside of solar cells**

(71) Applicant: Institut für Solarenergieforschung GmbH, 31860 Emmerthal (DE)
(72) Inventor: Schmidt, Jan, 31789 Hameln (DE); Zielke, Dimitri, 30459 Hannover (DE)
(74) Representative: Herzog, Fiesser & Partner Patentanwälte PartG mbB

(57) **Abstract**

The present invention relates to a solar cell (1) comprising a substrate (2) of p-type silicon or n-type silicon, wherein the substrate (2) comprises
- a front side (2a) the surface of which is at least partially covered with at least one passivation layer (3) and
- a back side (2b),
wherein
- the back side (2b) of the substrate (2) is at least partially covered with a passivation layer (4) having a thickness sufficient to allow a transport of holes through it,
and
- the passivation layer (4) on the backside 2b) of the substrate (2) is at least partially covered with a conductive polymer layer (5).

The present invention also relates to a process for the preparation of a solar cell, to a solar cell obtainable by this process and to a solar module.

## Description

### FIELD OF THE INVENTION

The present invention relates to a solar cell, a process for the preparation of a solar cell, to a solar cell obtainable by this process and to a solar module.

### BACKGROUND OF THE INVENTION

Solar cells are devices that convert the energy of light into electricity using the photovoltaic effect. Solar power is an attractive green energy source because it is sustainable and produces only non-polluting by-products. Accordingly, a great deal of research is currently being devoted to developing solar cells with enhanced efficiency while continuously lowering material and manufacturing costs. When light hits a solar cell, a fraction of the incident light is reflected by the surface and the remainder transmitted into the solar cell. The transmitted photons are absorbed by the solar cell, which is usually made of a semiconducting material, such as silicon which is often doped appropriately. The absorbed photon energy excites electrons of the semiconducting material, generating electron-hole pairs. These electron-hole pairs are then separated by p-n junctions and collected by conductive electrodes on the solar cell surfaces.

Solar cells are very commonly based on silicon, often in the form of a Si wafer. Here, a p-n junction is commonly prepared either by providing an n-type doped Si substrate and applying a p-type doped layer to one face or by providing a p-type doped Si substrate and applying an n-type doped layer to one face to give in both cases a so called p-n junction. Both n-type and p-type solar cells are possible and have been exploited industrially.

In order to achieve high efficiencies in solar cells it is necessary to minimize recombination losses in the solar cell. Here a distinction must be made between (i) recombination in the crystalline silicon wafer, (ii) the recombination at the non-metallized surfaces of the solar cell which can be passivated with dielectric layers such as SiO₂, SiNₓ or Al₂O₃, and (iii) the recombination at the metal-semiconductor junctions of the solar cell.

The high recombination at the metallized surface of a Si solar cell will more and more dominate the total loss of recombination as the passivation of not metallized areas with dielectric layers such as SiO₂, SiNₓ or Al₂O₃ increasingly finds its way into the production of solar cells. In order to approach the technologically feasible limit of the solar cell efficiency (about 25 %) it is essential to effectively reduce the recombination at the metal/semiconductor interfaces of the solar cell while avoiding that the contact resistance is not increased to an inacceptable extend.

In the last few years heterojunctions with amorphous silicon (a-Si) have proven to be an effective way of reducing the recombination at the metal/semiconductor interfaces. The deposition of the a-Si layer is usually effected by means of plasma enhanced chemical vapor deposition (*"Plasma Enhanced Chemical Vapor Deposition",* PECVD) using silane, hydrogen and diborane for the deposition of a p-type layer [a-Si (p)] or phosphine for the deposition of an n-type layer [a-Si (n)]. To achieve the required throughput by means of the a-Si/c-Si-heterojunction technology relatively thin a-Si layers are deposited by means of PECVD, resulting in an insufficient lateral conductivity. In order to reduce the layer resistance a transparent conductive layer such as an indium tin oxide (ITO) layer, is deposited on the a-Si layer. In view of the high efficiency potential of a-Si/c-Si-heterojunctions this solar cell technology is considered by many experts to be a realistic option for the next generation of industrial solar cells with efficiencies above 23 %.

However, the disadvantage in this approach has to be seen in the fact that, as an ITO-layer has to be deposited to reduce the sheet resistance, the material costs are quite high and the use of rare metals such as indium in solar cells is generally problematic, especially in the long term. Furthermore, gases such as phosphine or diborane are used for the doping of the a-Si layers and these gases are known and feared as being extremely dangerous poison gases.

A further approach for reducing the recombination at the metal/semiconductor interfaces of the solar cell is the use of Si/organic heterojunctions. Organic-silicon hybrid solar cells composed of an n-type crystalline silicon base and an organic poly(3,4-ethylenedioxythiophene) : poly(styrenesulfonate) (PEDOT : PSS) hole-conducting emitter layer provide a unique possibility to combine the high energy conversion efficiencies of crystalline silicon solar cells with the potentially low fabrication cost of organic solar cells. Schmidt et al. ("Organic-silicon heterojunction solar cells: Open-circuit voltage potential and stability"; Appl. Phys. Lett. 103, 183901 (2013)) have characterized the electronic properties of crystalline silicon (c-Si)/(PEDOT : PSS) junctions by means of contactless carrier lifetime measurements on silicon wafers and fabricated a solar cell in which the (c-Si)/(PEDOT : PSS) junction was localized at the textured front side.

However, the approach disclosed by Schmidt *et al.* (i. e. the application of PEDOT : PSS on the front side of the silicon solar cell) is characterized by several disadvantages. First of all, the PEDOT : PSS-layer on the solar cell front side is characterized by a strong parasitic absorption, which limits the short-circuit current of this cell type. Moreover, the refractive index of the PEDOT : PSS-layer is not optimal so that the PEDOT : PSS layer cannot serve as a good anti-reflective layer (compared to, for example, anti-reflective layers based on SiNₓ). Also, the contact resistance of the PEDOT : PSS layer is comparatively high and the stability of the solar cell disclosed by Schmidt *et al.* in humid air and towards UV-radiation is insufficient.

### SUMMARY OF THE INVENTION

The present invention is generally based on the object of overcoming at least one of the problems encountered in the state of the art in relation to solar cells.

More specifically, the present invention is further based on the object of providing solar cells with high efficiencies in which losses through recombination at the metal/semiconductor interfaces are reduced and which can be produced in a simple manner. Compared to solar cells known in the prior art that have been prepared for that purpose the solar cells according to the present invention should be characterized by an improved stability when being stored in a humid atmosphere and/or an improved stability towards UV-radiation.

A further object of the present invention is to provide processes for preparing solar cells, particularly n-type silicon solar cells, being characterized by the above mentioned properties, wherein the use of dangerous poison gases can be avoided and by means of which the solar cells can be produced in a simple and economic manner.

A contribution to achieving at least one of the above described objects is made by the subject matter of the category forming claims of the present invention. A further contribution is made by the subject matter of the dependent claims which represent specific embodiments of the invention.

### DETAILED DESCRIPTION OF THE INVENTION

A contribution to achieving at least one of the above described objects is made by a solar cell comprising a substrate of p-type silicon or n-type silicon, wherein the substrate comprises
- a front side the surface of which is at least partially covered with at least one passivation layer
   and
- a back side,
   wherein
- the back side of the substrate is at least partially covered with a passivation layer having a thickness sufficient to allow a transport of holes through it,
   and
- the passivation layer on the backside of the substrate is at least partially covered with a conductive polymer layer.

The solar cell according to the present invention is characterized by the fact that a conductive polymer layer, such as e. g. a polythiophene layer, a polypyrrole layer or a polyaniline layer, is deposited on the solar cell back side (i. e. the side of the solar cell that is not exposed to the sun) as a hole-transporting layer. Since conductive polymer layer is localized at back side of the solar cell, there will be no more relevant parasitic absorption and the non-optimal antireflection properties are also irrelevant. In addition, the conductive polymer layer in combination with the metal layer that is deposited on the whole surface acts as a good mirror for the infrared light passing through the solar cell. It therefore contributes in many ways to an increase of the photocurrent. In addition, the conductive polymer layer can now be completely metallized which leads to a significantly reduced contact resistance between the conductive polymer layer and the metal layer. Compared to a solar cell in which the conductive polymer layer is applied on the surface of the front side of the silicon wafer (like the solar cell disclosed by Schmidt *et al*.) and in which only a small area (< 10 %) of the conductive polymer layer is metallized with a metal grid, the total contact resistance in the solar cell according to the present invention with a conductive polymer layer on the back side of the silicon wafer is reduced by an order of magnitude.

Another significant advantage of the solar cell structure according to the present invention is its increased stability. The conductive polymer/c-Si-heterojunction localized on the back side of the solar cell is not exposed to UV photons since these photons are absorbed in the silicon wafer, resulting in an increased UV stability of the solar cell. Moreover, since the conductive polymer layer is completely covered with the metallization layer, which at the same time also acts as an "encapsulation", the conductive polymer layer does not come into direct contact with ambient air. This in turn leads to an increased stability as the absorption of moisture by the conductive polymer layer is avoided.

Furthermore, it has been observed that, in order to obtain high energy conversion efficiencies, it is an essential prerequisite that the interface between the silicon substrate and the hole-transporting conductive polymer layer is well passivated, i.e. the electron-hole recombination at the interface is minimized. In the present invention this is realized by implementing an ultrathin passivation layer in between the silicon substrate and the conductive polymer layer.

The solar cell according to the present invention comprises a substrate of p-type silicon or n-type silicon.

Doped Si substrates are well known to the person skilled in the art. The doped Si substrate can be prepared in any way known to the person skilled in the art and which he considers to be suitable in the context of the invention. Preferred sources of Si substrates according to the invention are based on amorphous silicon (a-Si), monocrystalline silicon (c-Si), multicrystalline silicon (mc-Si), upgraded metallurgical silicon (umg-Si), thin-film crystalline silicon (thinner than 50 µm) or a combination of at least two of these materials, wherein monocrystalline silicon (c-Si) is the preferred substrate material. Particularly preferred materials are n-doped or p-doped monocrystalline silicon, wherein n-doped monocrystalline silicon is the most preferred material for the substrate. Doping to form the doped Si substrate can be carried out simultaneously by adding a dopant during the preparation of the Si substrate or can be carried out in a subsequent step. Doping subsequent to the preparation of the Si substrate can be carried out for example by gas diffusion epitaxy. Doped Si substrates are also readily commercially available. According to the invention it is one option for the initial doping of the Si substrate to be carried out simultaneously to its formation by adding dopant to the Si mix.

It is known to the person skilled in the art that Si substrates can exhibit a number of shapes, surface textures and sizes. The shape can be one of a number of different shapes including cuboid, disc, wafer and irregular polyhedron amongst others. The preferred shape according to the present invention is wafer shaped where that wafer is a cuboid with two dimensions which are similar, preferably equal and a third dimension which is significantly less than the other two dimensions. Significantly less in this context is preferably at least a factor of about 100 smaller.

A variety of surface types are known to the person skilled in the art. According to the invention Si substrates with rough surfaces are preferred. One way to assess the roughness of the substrate is to evaluate the surface roughness parameter for a sub-surface of the substrate which is small in comparison to the total surface area of the substrate, preferably less than one hundredth of the total surface area, and which is essentially planar. The value of the surface roughness parameter is given by the ratio of the area of the subsurface to the area of a theoretical surface formed by projecting that subsurface onto the flat plane best fitted to the subsurface by minimising mean square displacement. A higher value of the surface roughness parameter indicates a rougher, more irregular surface and a lower value of the surface roughness parameter indicates a smoother, more even surface. According to the invention, the surface roughness of the Si substrate is preferably modified so as to produce an optimum balance between a number of factors including but not limited to light absorption and adhesion of fingers to the surface.

In this context it is preferred that the surface on the front side of the substrate (i. e. the side that is exposed to sun light) has a texture with maxima and minima. A particularly preferred texture has concave and convex patterns with a minute pyramid (i. e. square pyramid) shape. In a solar cell with such a texture at the front surface the light reflected from one spot impinges again to another spot on the surface of the crystalline solar cell by virtue of the textured surface, penetrating into the solar cell to be effectively absorbed in the solar cell. Although a portion of the impinging light that has not been fully absorbed, but arrives at the back face of the solar cell, is reflected back to the surface again, that portion of impinging light can be reflected again at the surface comprising steeply inclined pyramidal surfaces, thereby confining the light in the solar cell to improve absorption of light and to enhance power generation.

A textured structure including non-inverted pyramids can, for example, be formed by immersing the exposed face of a silicon wafer into a mixed solution prepared by adding 5 to 30% by volume of isopropyl alcohol into an aqueous solution of an alkaline, for example sodium hydroxide (NaOH) or potassium hydroxide (KOH), which may also include some added silicon. Etching in this mixed solution is performed at a temperature of from 70°C to 95°C. Further details for preparing textured structure on the surface of a Si wafer are, for example, disclosed in US 2004/0259335 A1, US 2013/0025663 A1 or WO 2012/025511 A1.

The surface of the front side of the substrate, preferably the surface of the front side of the n-type monocrystalline silicon waver, is at least partially covered with at least one passivation layer. Thorough passivation of the surface of a solar cell greatly improves the efficiency of the solar cell by reducing surface recombination. As used herein, "passivation" is defined as the chemical termination of dangling bonds present on the surface of a silicon lattice. Any passivation layer which is known to the person skilled in the art and which he considers to be suitable in the context of the invention can be employed. Preferred passivation layers according to the invention are silicon nitride layers, silicon oxide layers (SiOₓ), in particular a SiO₂ layer, silicon carbide layers (SiC), titanium oxide layers (TiOₓ), in particular a TiO₂ layer, aluminium oxide layers (AlOₓ), in particular a Al₂O₃ layer, a layer of amorphous silicon (a-Si), in particular a layer of n-doped amorphous silicon (a-Si (n)) or a layer stack comprising of an intrinsic undoped amorphous silicon layer (a-Si (i)) and Si n-doped amorphous silicon layer (a-Si (n)), in particular a double layer stack consisting of an a-Si0 (i)-layer and an a-Si (n)-layer, or a combination of at least two of these layers, wherein a SiNₓ layer is most preferred. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO). According to the invention, it is preferred for the passivation layer to have a thickness in a range from about 0.1 nm to about 1 µm, more preferably in a range from about 5 nm to about 500 nm and most preferably in a range from about 10 nm to about 250 nm.

Furthermore, the solar cell according to the present invention may further comprise an anti-reflection coating that is applied onto the passivation layer. Preferred anti-reflection coatings according to the invention are those which decrease the proportion of incident light reflected by the front face and increase the proportion of incident light crossing the front face to be absorbed by the wafer. All anti-reflection coatings known to the person skilled in the art and which he considers to be suitable in the context of the invention can be employed. Preferred anti-reflection coatings according to the present invention are those layers which have already been mentioned above as preferred passivation layers.

The thickness of anti-reflection coatings is suited to the wavelength of the appropriate light. According to the invention it is preferred for anti-reflection coatings to have a thickness in a range from about 20 to about 300 nm, more preferably in a range from about 40 to about 200 nm and most preferably in a range from about 60 to about 150 nm.

A single layer can serve as both, i.e. as an anti-reflection layer and as a passivation layer. In one embodiment of the solar cell according to the present invention, one or more layers which act as anti-reflection layer and/or passivation layer are present at the front side of the substrate. For example, the passivation layer can be a dielectric double layer comprising an aluminium oxide containing layer, preferably an Al₂O₃ layer, or a silicon oxide containing layer, preferably a SiO₂ layer, and a further layer covering the aluminium oxide or the silicon oxide containing layer, wherein the further layer is selected from the group consisting of a silicon nitride layer, in particular a Si₃N₄-layer, a silicon oxide layer, a silicon carbide layer or a combination of at least two of these layers, preferably a silicon nitride layer.

The application of the above mentioned layers can be performed by means of PECVD (plasma enhanced chemical vapor deposition), APCVD (atmospheric pressure chemical vapor deposition) or atomic layer deposition (ALD). The deposition of an n-doped a-Si passivation layer can be effected by means of PECVD using silane, hydrogen and phosphine, as it is, for example, disclosed in US 2007/0209699 A1.

The solar cell according to the present invention is characterized in that
- the back side of the substrate is at least partially covered with a passivation layer having a thickness sufficient to allow a transport of holes through it,
   and
- the passivation layer on the backside of the substrate (i. e. the surface of the passivation layer on the backside of the substrate that is facing away from the substrate) is covered with a conductive polymer layer.

The passivation layer on the backside of the substrate is preferably an ultrathin passivation layer that allows a transport of holes through it, for example, by exploiting the quantum mechanical tunneling effect. This passivation layer not only has to allow the transport of holes through it, it also has to reduce the interface state density to decrease interface recombination losses. In this context it is particularly preferred that the passivation layer on the backside of the substrate has a thickness of less than 5 nm, preferably less than 4 nm, more preferably less than 3 nm and most preferably less than 2 nm. Preferably, the thickness of the passivation layer on the backside of the substrate is in a range from 0.05 to 5 nm, more preferably 0.1 to 4 nm, even more preferably 0.15 to 3 nm and most preferably 0.2 to 2 nm. The thickness of the ultrathin passivation layer can, for example, be determined by high-resolution transmission electron microscopy (HRTEM).

The passivation layer on the backside of the substrate can comprise SiOₓ, in particular SiO₂. However, in an alternative embodiment of the solar cell according to the present invention this passivation may also comprise other passivating materials, such as aluminum oxide (AlOₓ) or titanium oxide (TiOₓ), wherein these materials can, for example, be deposited by atomic layer deposition (ALD), plasma-enhanced chemical vapor deposition (PECVD), atmospheric pressure chemical vapor deposition (APCVD) or electrochemical or chemical deposition. An alternative method for the reduction of the interface recombination losses between silicon and the conductive polymer layer is the deposition of an interface-passivating organic layer, such as a passivation layer comprising poly(3-hexylthiophene) (P3HT) allowing an effective hole transport through it. This type of interface passivation layer can, for example, be deposited from the liquid phase e.g. by spin-coating and is polymerized during annealing.

In a preferred embodiment of the solar cell according to the present invention the ultrathin passivation layer on the backside of the substrate comprises SiOₓ. Such a passivation layer is preferably formed by thermal oxidation of the surface of the substrate on the back side with oxygen. This can be accomplished by exposing the not-passivated surface at the back side of the substrate to oxygen for a predetermined time at a predetermined temperature, for example by thermal oxidation at very low temperature (preferably 20°C to 90°C for hours) or at increased temperature (400°C to 600°C for minutes). A simple way of producing the SiOₓ-containing layer is to expose the not-passivated surface at the back side of the substrate to ambient air conditions for a certain period of time at a predetermined temperature, for example for 1 hour to 7 days, preferably 5 hours to three days and most preferably 10 hours to 48 hours at a temperature in the range from 10°C to 200°C, preferably 20°C to 130°C and most preferably 20°C to 90°C.

The provision of an ultrathin passivation layer comprising SiOₓ on the backside of the substrate, however, can also be accomplished by other methods. According to one approach, the SiOₓ-layer can be prepared in a wet-chemical process wherein the back side of the substrate is treated, for example, with a nitric acid (HNO₃) solution, a sulfuric acid (H₂SO₄) solution of a hydrochloric acid (HCl) solution. When preparing the SiOₓ-layer with a nitric acid solution, for example, the back side of the substrate may be immersed in 20 to 100 wt.%, and preferably 50 to 80 wt.% nitric acid, for 1 to 30 minutes and preferably 5 to 10 minutes. According to a further approach the SiOₓ-layer can be prepared in an electrochemical process.

The above described passivation layer on the backside of the substrate is covered with a conductive polymer layer, wherein this conductive polymer layer serves as a hole-transporting layer in the solar cell.

As a conductive polymer conjugated polymers such as polypyrroles, polythiophenes, polyanilines, polyacetylenes or polyphenylenes can be used, wherein the use of polythiophenes is particularly preferred. According to a preferred embodiment of the solar cell according to the present invention the conductive polymer therefore comprises a polythiophene. Preferred polythiophenes are those having repeating units of the general formula (I) or (II) or a combination of units of the general formulas (I) and (II), preferably a polythiophene with repeating units of the general formula (II): 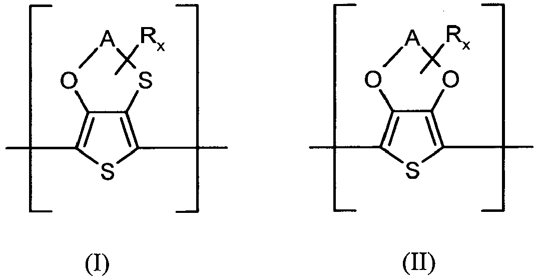 wherein
- A: stands for an optionally substituted C₁-C₅-alkylene radical,
- R: stands for a linear or branched, optionally substituted C₁-C₁₈-alkyl radical, an optionally substituted C₅-C₁₂-cycloalkyl radical, an optionally substituted C₆-C₁₄-aryl radical, an optionally substituted C₇-C₁₈-aralkyl radical, an optionally substituted C₁-C₄-hydroxyalkyl radical or a hydroxyl radical,
- x: stands for a whole number from 0 to 8 and
in the case where multiple radicals R are connected to A, these can be identical or different.

The general formulas (I) and (II) are to be so understood, that x substituents R can be connected to alkylene radical A.

Particularly preferred as polythiophene is poly(3,4-ethylenedioxythiophene).

The conductive polymer layer may further comprise a polymeric anion, preferably a polymeric anion based on polymers functionalised with acid groups, such as a polymeric sulfonic acid or a polymeric carboxylic acid. Particularly suitable as polymeric anion is polystyrene sulphonic acids (PSS).

According to a particularly preferred embodiment of the solar cell according to the present invention the conductive polymer layer comprises a polythiophene being present in the form of a polythiophene: polymeric anion complex, wherein a poly(3,4-ethylenedioxythiophene) : polystyrene sulfonic acid complex (also referred to as "PEDOT : PSS") is particularly preferred. Such a complex can be obtained if the monomers on which the polythiophene is based (such as 3,4-ethylenedioxythiophene) are polymerized in the presence of the polymeric anion in an aqueous solution as disclosed by Kirchmeyer et al. in the Journal of Materials Chemistry (2005), 15(21), pages 2077-2088.

The layer thickness of the conductive polymer layer preferably lies in a range from 1 nm to 10 µm, particularly preferably in a range from 10 nm to 500 nm and most preferably in a range from 20 nm to 200 nm. The surface resistance of the conductive polymer layer preferably lies in a range from 1 to 5000 Ω/sq, preferably in a range from 10 to 1000 Ω/sq and most preferably in a range from 10 to 250 Ω/sq.

The solar cell according to the present invention further comprises two metal containing layers forming the electrical poles of the solar cell.

According to a first particular embodiment of the solar cell according to the present invention the solar cell is configured to have a first electrode at the front side and a second electrode at the back side of the solar cell.

According to a second particular embodiment of the solar cell according to the present invention the solar cell is configured to have both electrodes on the back side of the solar cell. This structure is also called "*back contact, backjunction (BCBJ) solar".*

### Solar cell according to the first particular embodiment

In this particular embodiment the solar cell is configured to have a first electrode at the front side and a second electrode at the back side of the solar cell. In this context it is preferred that the solar cell comprises a first metal containing layer being in an electrically conductive contact with the front side of the substrate and a second metal containing layer being in an electrically conductive contact with the conductive polymer layer at the back side of the substrate.

The first metal containing layer being in an electrically conductive contact with the front side of the substrate is preferably applied in the form of a metal grid or in the form of a pattern comprising at least one metal busbar and metal fingers to allow light to be absorbed by the exposed silicon surface. The front grid or the front fingers can be deposited in embedded grooves to reduce shading losses. This type of solar cell is often known as a *"Buried Contact solar cell"* (also referred to as a *"Laser Grooved Buried Grid (LGBG) solar cell".* Such a solar cell is, for example, disclosed in EP 0 156 366 A2.

The metal containing layer at the front side of the substrate can, for example, be based on aluminum (Al), gold (Au), silver (Ag), nickel (Ni) coated with copper (Cu) or chromium (Cr) coated with gold(Au) or silver (Ag) or a stack comprising titanium (Ti), palladium (Pd) and silver (Ag). In industry, for forming a silver grid, a silver containing paste (which often includes silver particles, an organic binder and glass frit) is printed onto the wafers and then fired at temperature between 700°C and 900°C. The high-temperature firing of the silver paste ensures a good contact between silver and silicon, and lowers the resistivity of the silver lines. Furthermore, conventional thin film evaporation techniques, such as electron beam evaporation, can be used for forming a metal grid or a pattern comprising at least one metal busbar and metal fingers on the front surface of the solar cell. For forming the pattern shadow masks can be used or the pattern can be formed by means of conventional photolithographic techniques.

The second metal containing layer being in an electrically conductive contact with the conductive polymer layer at back side of the substrate is preferably applied directly onto the conductive polymer layer. As stated above, this "encapsulation" of the conductive polymer layer leads to an increased stability as the absorption of moisture by conductive polymer layer, in particular if this conductive polymer layer is based on PEDOT : PSS, is avoided. In this context it is preferred that at least 50 %, more preferably at least 75 % and even more preferred at least 95 % of the total surface of the conductive polymer layer is covered with the second metal containing layer, wherein it is most preferred that essentially the whole surface of the conductive polymer layer is covered with the second metal containing layer.

By directly applying the metal containing layer at the back side of the substrate to the conductive polymer layer, the following layer sequence is obtained at the backside:
- back side of the substrate (preferably the backside of the n-doped monocrystalline silicone wafer)
- passivation layer on the backside of the substrate, preferably an ultrathin passivation layer comprising SiOₓ
- conductive polymer layer, preferably a conductive polymer layer comprising a polythiophene
- metal containing layer (back side electrode)

The metal containing layer at the back side of the substrate can also be based on aluminum (Al), gold (Au), silver (Ag), nickel (Ni) coated with copper (Cu) or chromium (Cr) coated with gold (Au) or silver (Ag), or stacks comprising titanium (Ti), palladium (Pd) and silver (Ag), wherein a silver layer is preferred as the metal containing layer at the back side. For forming a silver layer, a silver-containing polymer-based paste can be applied onto the conductive polymer layer and then low-temperature fired at appropriate temperatures (i. e. < 200°C). Such pastes are commercially available and are today routinely used in the production of a-Si/c-Si heterojunction cells. Furthermore, conventional thin film evaporation techniques, such as electron beam evaporation or sputtering, can be used for applying a metal layer onto the conductive polymer layer.

The thickness of the metal containing layer at the back side of the substrate is usually within the range of 0.1 to 100 nm, more preferably within the range of 0.5 to 30 nm and most preferably within the range of 1 to 5 nm.

In connection with the solar cell according to the first particular embodiment it is furthermore preferred that the substrate, preferably the n-type monocrystalline silicon wafer, at the front side and beneath the passivation layer comprises an n-doped front surface field (n⁺-FSF). If the substrate comprises an n⁺-FSF, the metal containing layer at the front side of the substrate is in electrically conductive contact with at least a portion of the n⁺-FSF.

The presence of a heavily doped region at the front side of the substrate allows much better electrical contact between the solar cell and the metallic contacts at the front side and significantly lowers the series resistance of the solar cell. The use of heavily n-doped regions on the front side surface also has the advantage of a higher efficiency of the solar cells due to reduced recombination losses under the metalized area due to the strongly reduced hole concentration within the n⁺-FSF. The layer resistance of the n⁺-FSF is preferably in a range of 10 to 500 ohm/sq.

Preferred n-type dopants according to the invention are those which add electrons to the Si wafer band structure. They are well known to the person skilled in the art. All dopants known to the person skilled in the art and which he considers to be suitable in the context of the invention can be employed as n-type dopant. Preferred n-type dopants according to the invention are elements of group 15 of the periodic table. Preferred group 5 elements of the periodic table in this context include N, P, As, Sb or a combination of at least two thereof, wherein P is particularly preferred. In one embodiment of the invention, the n-doped layer comprises P as dopant.

An n⁺-FSF can be made for example by means of a gas diffusion step at a temperature of 800-950°C for several tens of minutes, as described for example in document J.C.C. Tsai, "Shallow Phosphorus Diffusion Profiles in Silicon", Proc. of the IEEE 57 (9), 1969, p. 1499-1506, or by means of an ion implantation of phosphorus atoms, followed by a step of thermal activation of the implanted atoms, as described for example in the publication of Meier et al., "N-Type, ion Implanted silicon solar cells and modules", Proc. 37 th PVSC, LA, page 3337.

### Solar cell according to the second particular embodiment

In this particular embodiment the solar cell is configured to have both electrodes on the back side of the solar cell (*"back contact, back junction (BCBJ)"*). In this embodiment the solar cell comprises a first metal containing layer being in an electrically conductive contact with the back side of the substrate and a second metal containing layer being in an electrically conductive contact with the conductive polymer layer on the back side of the substrate.

Such BCBJ-cell has a higher efficiency potential compared to a solar cell in which both sides are contacted as the shadowing at the front side can be omitted. With conventional high temperature diffusion, however, the processing is complex and requires a high number of process steps including masking steps for locally generating n⁺- and p⁺-regions on the back side of the cell. By local application of a conductive polymer layer such as a PEDOT : PSS-layer on the back side of the solar cell, for example by screen printing, the processing of such BCBJ-cell is greatly simplified as only the conventionally produced phosphorus-diffused n⁺-region has to be masked. The conventionally produced n⁺-region shows a higher recombination than the conductive polymer/n-Si -junction. However, since the n⁺-contact region in n-type silicon based BCBJ-solar cells is advantageously limited to a small area (typically ≤ 20%) and as the conductive polymer/n-Si -junction is characterized by a good passivation effect, it is still possible to achieve a high efficiency with a simple process sequence.

In the second particular embodiment of the solar cell according to the present invention the back side of the solar cell comprises two patterned structures:
- In the first patterned structure selected regions on the back side of the substrate are provided with n⁺-regions. The regions of this first patterned structure are in an electrically conductive contact with a first grid forming the first metal containing layer.
- In the second patterned structure further selected regions on the back side of the substrate are covered with the passivation layer on the backside of the substrate, preferably the ultrathin passivation layer comprising SiOₓ, which is then covered with the conductive polymer layer, preferably with a conductive polymer layer comprising a polythiophene. The regions of this patterned structure are in contact with a second grid forming the second metal containing layer.

In this context it is preferred that not more than 50 %, preferably not more than 30 % an most preferably not more than 20 % of the total area on the back side of the solar cell is provided with an n⁺-regions.

In addition to the layers described above which directly contribute to the principle function of the solar cell according to the present invention, in particular the solar cell according to the above described first and second particular embodiment, further layers can be added for mechanical and chemical protection.

The solar cell can be encapsulated to provide chemical protection. Encapsulations are well known to the person skilled in the art and any encapsulation can be employed which is known to him and which he considers suitable in the context of the present invention. According to the present invention, transparent polymers, often referred to as transparent thermoplastic resins, are preferred as the encapsulation material, if such an encapsulation is present. Preferred transparent polymers in this context are for example silicon rubber and polyethylene vinyl acetate (PVA).

A transparent glass sheet can be added to the front side of the solar cell to provide mechanical protection. Transparent glass sheets are well known to the person skilled in the art and any transparent glass sheet known to him and which he considers to be suitable in the context of the present invention can be employed as protection on the front side of the solar cell.

A back protecting material can be added to the back side of the solar cell to provide mechanical protection. Back protecting materials are well known to the person skilled in the art and any back protecting material which is known to the person skilled in the art and which he considers to be suitable in the context of the present invention can be employed as protection on the back face of the solar cell. Preferred back protecting materials according to the present invention are those having good mechanical properties and weather resistance. The preferred back protection material according to the present invention is polyethylene terephthalate with a layer of polyvinyl fluoride. It is preferred according to the present invention for the back protecting material to be present underneath the encapsulation layer (in the event that both a back protection layer and encapsulation are present).

A frame material can be added to the outside of the solar cell to give mechanical support. Frame materials are well known to the person skilled in the art and any frame material known to the person skilled in the art and which he considers suitable in the context of the present invention can be employed as frame material. The preferred frame material according to the present invention is aluminum.

A contribution to achieving at least one of the above described objects is also made by a process for the preparation of a solar cell comprising the process steps:
I) providing a substrate of p-type silicon or n-type silicon, wherein the substrate comprises
   - a front side
      and
   - a back side;
II) covering at least a part of the surface of the substrate on the back side with a passivation layer having a thickness sufficient to allow a transport of holes through it, preferably with an ultrathin passivation layer comprising SiOₓ;
III) covering at least a part of the surface of the passivation layer on the back side of the substrate (i. e. the surface facing away from the substrate) with a conductive polymer layer, preferably a conductive polymer layer comprising a polythiophene; and
IV) covering at least a part of the surface of the conductive polymer layer (i. e. the surface facing away from the surface of the passivation layer that has been prepared in process step II) with a metal containing layer (6).

In process step I) of the process according to the present invention a substrate of p-type silicon or n-type silicon is provided, wherein the substrate comprises a front side and a back side.

Preferred substrates are those that have already been mentioned as preferred substrates in connection with the solar cell according to the present invention, wherein a n-doped monocrystalline silicon wafer is the most preferred substrate.

As already described in connection with the solar cell according to the present invention the front side of the substrate (i. e. the side that is exposed to the sun light) can have a texture with maxima and minima, wherein those textures are preferred that have already been described in connection with the solar cell according to the present invention (i. e. a concave and convex pattern with a minute pyramid (i. e. square pyramid) shape).

The front side of the substrate that is provided in process step I) may at least partially be covered with at least one passivation layer. However, it is also possible to apply such a passivation layer (or such passivation layers) onto the surface of the front side of the substrate after performing process step II) or process step III). Preferred passivation layers are again those passivation layers that have already been described in connection with the solar cell according to the present invention (i. e. silicon nitride layers, silicon oxide layers (SiOₓ), in particular a SiO₂ layer, silicon carbide layers (SiC), titanium oxide layers (TiOₓ), in particular a TiO₂ layer, aluminium oxide layers (AlOₓ), in particular a Al₂O₃ layer, a layer of amorphous silicon (a-Si), in particular a layer of n-doped amorphous silicon (a-Si (n)) or a layer stack comprising of an intrinsic undoped amorphous silicon layer (a-Si (i)) and Si n-doped amorphous silicon layer (a-Si (n)), in particular a double layer stack consisting of an a-Si0 (i)-layer and an a-Si (n)-layer, or a combination of at least two of these layers), wherein layers of SiNₓ are most preferred. These layers may also simultaneously function as anti-reflection layers, as already mentioned in connection with the solar cell according to the present invention. If a layer of amorphous silicon (a-Si) or a layer stack comprising of an intrinsic undoped amorphous silicon layer (a-Si (i)) and Si n-doped amorphous silicon layer (a-Si (n)) is used as the passivation layer, it is furthermore preferred that the passivation layer is covered with a layer of a transparent conductive coating, preferably a transparent conductive oxide (TCO) such as indium tin oxide (ITO).

The application of the above mentioned layers can be performed by means of PECVD (plasma enhanced chemical vapor deposition), APCVD (atmospheric pressure chemical vapor deposition) or atomic layer deposition (ALD).

Depending on the kind of solar cell that is produced by the process according to the present invention (i. e. a solar cell that is configured to have a first electrode at the front side and a second electrode at the back side of the solar cell or a solar cell that is configured to have both electrodes on the back side of the solar cell) the substrate provided in process step I) may comprise further layers.
- If the solar cell is configured to have a first electrode at the front side and a second electrode at the back side of the solar cell, the substrate may further comprise a n-doped front surface field (n⁺-FSF) as described in connection with the first particular embodiment of the solar cell according to the present invention. This n-doped front surface field may further be in an electrically conductive contact with the first electrode, which may have been applied in the form of a grid or in the form of a pattern comprising at least one metal busbar and metal fingers.
- If the solar cell is configured to have both electrodes on the back side of the solar cell, the substrate may comprise n⁺-areas in the form of a pattern on the back side of the solar cell, as already described in connection with the second particular embodiment of the solar cell according to the present invention.

In process step II) of the process according to the present invention the surface of the substrate on the back side is covered with a passivation layer having a thickness sufficient to allow a transport of holes through it, wherein the ultrathin passivation layer - as already stated in connection with the solar cell according to the present invention - may comprise passivating materials such as SiOₓ, AlOₓ, TiOₓ or P3HT and wherein ultrathin passivation layers comprising SiOₓ are particularly preferred.

As already described in connection with the solar cell according to the present invention an ultrathin passivation layer comprising SiOₓ is preferably formed by thermal oxidation of the surface of the substrate on the back side with oxygen, for example at very low temperature (preferably 20°C to 90°C for hours) or at increased temperature (400°C to 600°C for minutes). According to a one embodiment of the process according to the present invention the not-passivated surface at the back side of the substrate that has been provided in process step I) is exposed to ambient air conditions for a certain period of time at a predetermined temperature, for example for 1 hour to 7 days, preferably 5 hours to three days and most preferably 10 hours to 48 hours at a temperature in the range from 10°C to 200°C, preferably 20°C to 130°C and most preferably 20°C to 90°C. As already stated in connection with the solar cell according to the present invention, a passivation layer comprising SiOₓ can also be prepared in a wet-chemical process using acid solutions based on HNO₃, H₂SO₄ or HCl of in an electrochemical process.

When passivation materials such as AlOₓ or TiOₓ are used for the formation of the ultrathin passivation layer, these materials can be deposited by atomic layer deposition (ALD), plasma-enhanced chemical vapor deposition (PECVD), atmospheric pressure chemical vapor deposition (APCVD) or electrochemical or chemical deposition, whereas a passivation layer comprising P3HT can, for example, be deposited from the liquid phase e.g. by spin-coating and is polymerized during annealing.

The thickness of the ultrathin passivation layer, preferably the ultrathin passivation layer comprising SiOₓ prepared in process step II) is preferably less than 5 nm, more preferably less than 4 nm, even more preferably less than 3 nm and most preferably less than 2 nm. Preferably, the thickness is in a range from 0.05 to 5 nm, more preferably 0.1 to 4 nm, even more preferably 0.15 to 3 nm and most preferably 0.2 to 2 nm. The thickness of the ultrathin passivation layer can, for example, be determined by high-resolution transmission electron microscopy (HRTEM).

In process step III) of the process according to the present invention the passivation layer on the back side of the substrate, preferably the ultrathin passivation layer comprising SiOₓ, that has been produced in process step II) is covered with a conductive polymer layer, wherein as conductive polymer those polymers are preferred that have already been mentioned as the preferred conductive polymers in connection with the solar cell according to the present invention. According to a particularly preferred embodiment of the process according to the present invention the conductive polymer layer prepared in process step III) comprises a polythiophene, wherein those polythiophenes are preferred that have already been mentioned in connection with the solar cell according to the present invention.

According to a preferred embodiment of the process according to the present invention the conductive polymer layer is formed by applying a solution, emulsion or dispersion comprising the conductive polymer and a solvent or dispersant onto the passivation layer on the back side of the substrate and by subsequently removing at least a part of the solvent or dispersant.

The solution, emulsion or dispersion may further comprise a polymeric anion, wherein preferred polymeric anions are those that have already been mentioned in connection with the solar cell according to the present invention. Particularly preferred solutions, emulsions or dispersions are those comprising a polythiophene : polymeric anion complex, in particular solutions, emulsions or dispersions comprising PEDOT : PSS. As stated above, such solutions, emulsions or dispersions can be obtained if the monomers on which the polythiophene is based (such as 3,4-ethylenedioxythiophen) are polymerized in the presence of the polymeric anion in an aqueous solution.

The solutions, emulsions or dispersions used to prepare the conductive polymer layer can be applied onto the passivation layer on the backside of the substrate, preferably onto the ultrathin passivation layer comprising SiOₓ, prepared in process step II) by known processes, for example by spin-coating, impregnating, casting, dropwise application, spraying, knife-coating, painting or printing, for example inkjet printing, screen printing or pad printing, wherein the method of applying the solution, emulsion or dispersion also depends on the structure of the solar cell. If, for example, the solar cell is configured to have both electrodes on the back side of the solar cell and if therefore the layer of the conductive polymer has to be applied in the form of a pattern to only cover selected areas of the back side of the solar cell, techniques such as inkjet printing are preferred.

After the solution, emulsion or dispersion has been applied, the solvent or dispersant is preferably removed for the formation of the conductive polymer layer. Removal of the solvent or dispersant is preferably achieved by simple evaporation at a drying temperature in the range from 10 to 250°C, preferably 50 to 200°C and more preferably 80 to 150°C for a period of 1 second to 24 hours, preferably 10 seconds to 10 minutes and more preferably 15 seconds to 2 minutes. The thickness of the conductive polymer layer thus applied preferably lies in a range from 1 nm to 10 µm, particularly preferably in a range from 10 nm to 500 nm and most preferably in a range from 20 nm to 200 nm. The surface resistance of the conductive polymer layer thus applied preferably lies in a range from 1 to 5000 Ω/sq, preferably in a range from 10 to 1000 Ω/sq and most preferably in a range from 10 to 250 Ω/sq.

In process step IV) of the process according to the present invention at least a part of the surface of the conductive polymer layer (i. e. the surface facing away from the passivation layer on the back side of the substrate, preferably the ultrathin passivation layer comprising SiOₓ) is covered with a metal containing layer, wherein the way of covering the conductive polymer layer with the metal containing layer again depends on the structure of the solar cell.
- If the solar cell is configured to have a first electrode at the front side and a second electrode at the back side of the solar cell, it is preferred that almost the entire surface of the back side of the substrate is covered with a conductive polymer layer and that almost the entire surface of the conductive polymer layer is covered with the metal containing layer serving as the electrode on the back side of the solar cell. In this embodiment the second electrode of the solar cell is applied in the form of a grid of in the form of a pattern comprising at least one metal busbar and metal fingers at the front side of the solar cell.
- If the solar cell is configured to have both electrodes on the back side of the solar cell, the metal containing layer is only applied onto those areas on the back side of the solar cell which are covered with the conductive polymer layers. The remaining areas (i. e. the n⁺-areas) are covered by a separate metal containing layer.

The metal containing layer that is used to cover the conductive polymer layer comprising polythiophenes can be based on aluminum (Al), gold (Au), silver (Ag), nickel (Ni) coated with copper (Cu) or chromium (Cr) coated with Au or a stack comprising titanium (Ti), palladium (Pd) and silver (Ag), wherein a silver layer is preferred as the metal containing layer at the back side. For forming a silver layer, a silver-containing polymer-based paste can be applied onto the conductive polymer layer and then low-temperature fired at appropriate temperatures (i.e. <200°C). Such pastes are commercially available and are today routinely used in the production of a-Si/c-Si heterojunction cells. The way of applying the metal containing layer again depends on the solar cell that is prepared (i. e. if the metal containing layer is applied extensively onto the whole surface of the back side of the substrate, as it is the case for the first particular embodiment of the solar cell according to the present invention, or if the metal containing layer is applied in the form of a pattern only onto selected areas on the back side of the substrate, as it is the case for the second particular embodiment of the solar cell according to the present invention).

A contribution to achieving at least one of the above mentioned objects is also made by a solar cell obtainable by the process according to the present invention.

A contribution to achieving at least one of the above mentioned objects is also made by a module comprising at least a solar cell according to the present invention or at least a solar cell obtained by the process according to the present obtained, in particular according to at least one of the above described embodiments, and at least one more solar cell. A multiplicity of solar cells according to the present invention can be arranged spatially and electrically connected to form a collective arrangement called a module. Preferred modules according to the present invention can take a number of forms, preferably a rectangular surface known as a solar panel. Large varieties of ways to electrically connect solar cells as well as large varieties of ways to mechanically arrange and fix such cells to form collective arrangements are well known to the person skilled in the art and any such methods known to him and which he considers suitable in the context of the present invention can be employed. Preferred methods according to the present invention are those which result in a low mass to power output ratio, low volume to power output ration, and high durability. Aluminium is the preferred material for mechanical fixing of solar cells according to the present invention.

### DESCRIPTION OF THE DRAWINGS

The present invention is now explained by means of figures which are intended for illustration only and are not to be considered as limiting the scope of the present invention. In brief,
Fig. 1 shows a side view of a solar cell 1 according the first particular embodiment of the present invention, wherein a first electrode 7 is localized at the front side 2a and a second electrode 6 is localized at the back side 2b of the solar cell 1;
Fig. 2 shows a cross sectional view of the solar cell 1 shown in fig. 1;
Fig. 3 shows a cross sectional view of a solar cell 1 according the second particular embodiment of the present invention, wherein both electrodes 6,7 are localized at the back side 2b of the solar cell 1 *("back contact, back junction (BCBJ)"*).

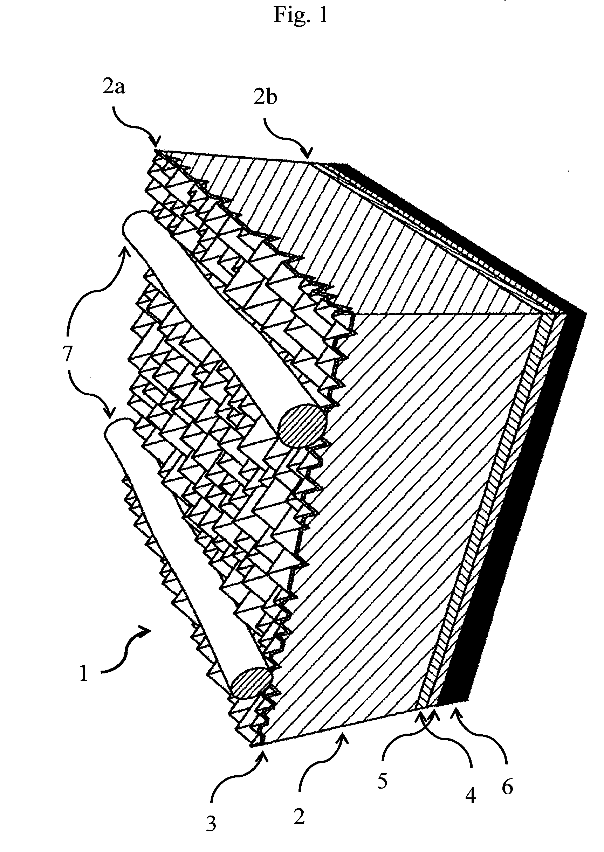

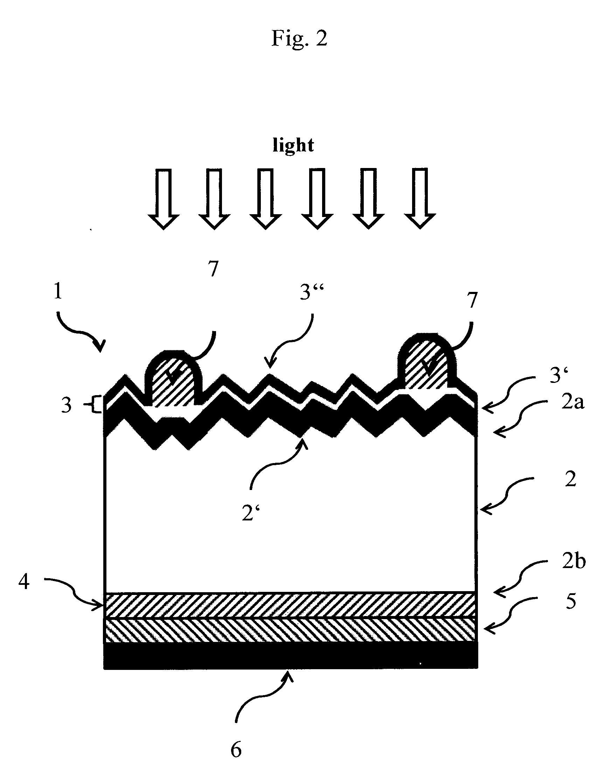

Figures 1 and 2 show a realization form of the solar cell 1 according the first particular embodiment of the present invention, wherein a first electrode 7 is localized at the front side 2a and a second electrode 6 is localized at the back side 2b of the substrate 2. This solar cell structure is characterized by a conventionally processed RP-textured front side 2a that was provided with a phosphorus-diffused electron collecting n⁺-layer 2' (the so called *"n*⁺*-Front Surface Field",* n⁺-FSF). The front side 2a (i. e. the n⁺-FSF) was coated with an Al₂O₃ tunnel layer 3', metallized with aluminum and then passivated with a SiNₓ-layer 3". The front side 2a was made with a standard process developed by the Institute for Solar Energy Research Hamelin (ISFH) and described by D. Zielke et al., "Contact passivation in silicon solar cells using atomic-layer-deposited aluminum oxide layers". Phys. Stat. Sol. RRL 5, 298-300 (2011). On the back side 2b of the solar cell 1 the hole-transporting PEDOT : PSS/c-Si heterojunction is localized, which was completely metallized with evaporated silver (Ag) forming the back electrode 6.

For the production of the solar cell 1 as shown in figures 1 and 2 a monocrystalline n-type silicon wafer 2 with a resistivity of 1.5 Ωcm and a thickness of 160 µm is used as the starting material. The wafer 2 is cleaned with an RCA sequence and protected on both sides with a SiNₓ-layer having a thickness of 100 nm and being deposited by PECVD. On one side of the passivated silicon wafer a 2 x 2 cm diffusion window was opened in the SiNₓ layer by laser ablation (frequency-doubled Nd : YVO₄ laser, SuperRapid, Lumera ). In the opened SiNₓ-window a random pyramid texture is produced by means of a KOH/isopropanol solution. After further purification, phosphorus diffusion is performed in the open and textured SiNₓ window with a POCl₃ source in a quartz tube furnace at 850°C. The resulting n⁺-FSF 2' has a sheet resistance of 100 ± 50 Ω/sq. The SiNₓ protective layer and the phosphorus-silicate glass are completely removed using diluted fluoric acid and the textured side of the wafer 2 is coated with an Al₂O₃ tunnel layer 3' having a thickness of 0.24 nm and being deposited by means of atomic layer deposition. Thereafter, an aluminum grid 7 with a thickness of 20 µm and a finger pitch of 1 mm is deposited by electron beam evaporation using nickel shadow masks on the textured front side 2a. The metallized front side 2a is coated with a passivating SiNₓ layer with a refractive index of 2.4 and above with a 70 nm thick SiNₓ anti-reflection layer having a refractive index of 1.9. The two SiNₓ layers together are indicated by reference number 3" in figure 2 and are deposited at 330°C by PECVD. The solar cell 1 is then stored for 24 hours in ambient air in order to grow a native SiOₓ layer 4 on the untextured back side 2b of the solar cell 1. After 24 hours of storage, a PEDOT : PSS layer 5 having a thickness of 140 nm has been applied onto the SiOx-layer 4 by spin coating (500 revolutions per minute for 10 seconds, followed by 1000 rpm for 20 seconds) a PEDOT : PSS-dispersion (F HC Solar, Heraeus Clevios GmbH) on the untextured side of the cell. The cells are then dried at 130°C for 30 seconds on a hot plate. The sheet resistance of the PEDOT : PSS layer 5 that has been deposited at the back side 2b of the solar cell 1 is 120 ± 10 Ω/sq. Finally, the entire surface of the PEDOT : PSS layer 5 is coated with a silver layer 6. The silver coating has been performed by electron beam evaporation

As a full-surface silver vapor-deposition is rather uneconomic for an industrially manufactured solar cell, the back side 2b can also be metallized by other methods. One approach that is used in industry for many years in connection with a-Si/c-Si heterojunction cells is the use of silver-containing polymer pasts. In this approach a silver containing paste that can be tempered at temperatures that are compatible with PEDOT : PSS is applied by screen printing and is subsequently tempered. Another possibility of applying a metallic layer on the back side of the solar cell is the use of galvanic deposition.

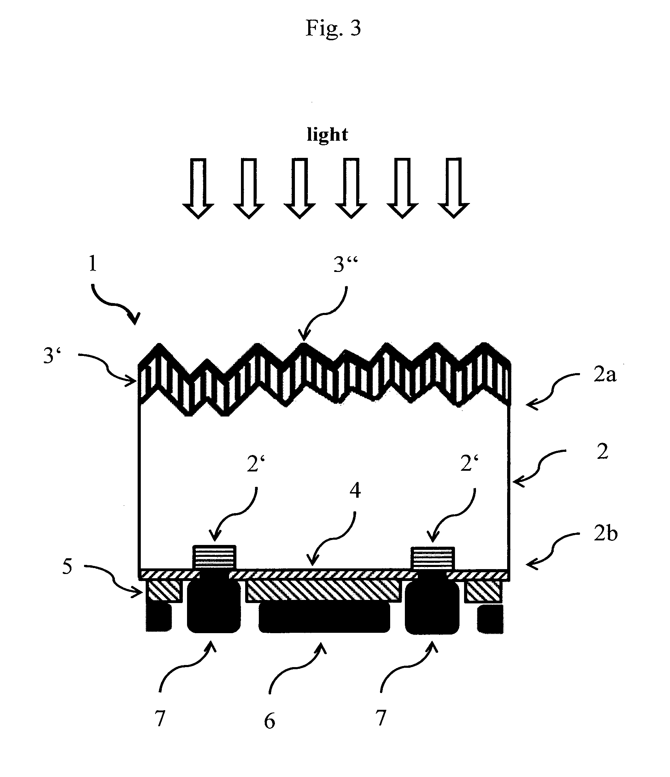

Figure 3 shows a cross sectional view of a solar cell 1 according the second particular embodiment of the present invention, wherein both electrodes 6,7 are localized at the back side 2b of the substrate 2 *("back contact, back junction (BCBJ)"*). This solar cell structure characterized in that the front side 2a is completely unmetallized and is only RP-textured to improve light coupling. The front side is passivated with a SiO₂/SiNₓ-layer sequence 3',3" (wherein the SiNₓ-layer is the outer layer), which also acts as an anti-reflection coating. On the back side 2b phosphorus-diffused n⁺-regions 2' for contacting the n-type substrate 2 are produced locally and, as a hole-conducting layer, a conductive polymer layer 5 is applied. Metallization is effected by means of two independent grids 6,7, which are electrically isolated by gaps. The non-metallized part of the n⁺- region is passivated by a SiOₓ-containing layer 4 as well as the gap between the n⁺-region 2' and the conductive polymer layer 5 on the back side 2b of the substrate 2 in order to minimize the losses through surface recombination.

For preparing a BCBJ-solar cell 1 shown in figure 3 a monocrystalline n-type silicon wafer 2 with a resistivity of 1-6 Ωcm and a thickness of 160 µm is used as the starting material. The wafer 2 is cleaned with an RCA sequence and protected on one side with a SiNₓ-layer having a thickness of 100 nm and being deposited by PECVD. On the uncoated side of the wafer 2 a random pyramid (RP) texture is produced in a KOH/isopropanol solution. After wet-chemical cleaning the RP-textured side 2a of the wafer 2 is protected with a PECVD-deposited SiNₓ layer. Thereafter strips with a width of 200 µm and a distance of 2 mm from each other are opened on the untextured, planar side 2b of the wafer 2 in the SiNₓ protective layer by laser ablation (frequency-doubled Nd: YVO4 laser, Super Rapid, Lumera). After wet-chemical cleaning, a phosphorus diffusion is performed in the open areas on the untextured side 2b. The diffusion is accomplished with a POCl₃ source in a quartz tube furnace at 850°C. The resulting n⁺-regions 2' have a sheet resistance of 100 ± 70 Ω/sq. The SiNₓ protective layers and the phosphorus-silicate glass are completely removed using diluted fluoric acid solution and the wafer 2 is oxidized on both sides in a quartz tube furnace at 900°C in a wet oxidation in order to grow a 10 nm SiO₂ passivating layer 3',4 on both surfaces. Onto the SiO₂ passivating layer 3' on the textured front side 2a a SiNₓ-layer 3" having a thickness of 80 nm is deposited by PECVD to improve the anti-reflection effect and the passivating effect on the front side 2a. On the back side 2b the SiO₂ layer is locally removed, for example by means of inkjet technology and etching in hydrofluoric acid or by means of laser ablation. The SiO₂ layer only remains on a small part of the n⁺-regions and on the edge region between the n⁺-region and the area that will later on form the PEDOT : PSS/c-Si junction. After 24 hours of storage for the growth of a natural interfacial oxide 4, the conductive polymer layer 5, such as a PEDOT : PSS layer, is locally applied in the regions between the n⁺-type lines. This can, for example, be effected by means of screen printing or inkjet printing. The solar cell 1 is then dried at 130°C for 30 seconds on a hot plate. The sheet resistance of the PEDOT : PSS layer 5 that has been deposited at the back side 2b of the solar cell 1 is 120 ± 10 Ω/sq. Finally, the PEDOT : PSS layer 5 is metallized locally with a first grid 6 that only contacts the PEDOT : PSS layer 5, and a second, finer grid 7 that contacts the n⁺-regions 2'.

### LIST OF REFERENCE NUMBERS

- 1: solar cell
- 2: substrate (i. e. n-type or p-type Si wafer, preferably n-doped c-Si)
- 2': n⁺-region
- 2a: front side
- 2b: back side
- 3: passivation layer
- 3': Al₂O₃ layer or SiO₂ layer
- 3": SiNₓ layer
- 4: ultrathin passivation layer, preferably an ultrathin passivation layer comprising SiOₓ
- 5: conductive polymer layer (preferably a PEDOT : PSS layer)
- 6: metal containing layer (first electrode)
- 7: metal containing layer (second electrode)

## Claims

1. A solar cell (1) comprising a substrate (2) of p-type silicon or n-type silicon, wherein the substrate (2) comprises
- a front side (2a) the surface of which is at least partially covered with at least one passivation layer (3)
and
- a back side (2b),
wherein
- the back side (2b) of the substrate (2) is at least partially covered with a passivation layer (4) having a thickness sufficient to allow a transport of holes through it,
and
- the passivation layer (4) on the backside (2b) of the substrate (2) is at least partially covered with a conductive polymer layer (5).

2. The solar cell according to claim 1, wherein the passivation layer (4) on the backside of the substrate comprises SiOₓ and has a thickness of less than 5 nm.

3. The solar cell (1) according to claim 1 or 2, wherein the conductive polymer layer (5) comprises polythiophenes.

4. The solar cell (1) according to anyone of the preceding claims, wherein the substrate (2) is based on n-type monocrystalline silicon (c-Si).

5. The solar cell (1) according to anyone of the preceding claims, wherein the at least one passivation layer (3) is selected from the group consisting of a silicon nitride layer (SiNₓ), a silicon oxide layer (SiOₓ), a silicon carbide layer (SiC), a titanium oxide layer (TiOₓ), an aluminium oxide layer (AlOₓ), a layer of amorphous silicon (a-Si) or a layer stack comprising of an intrinsic undoped amorphous silicon layer (a-Si (i)) and Si n-doped amorphous silicon layer (a-Si (n)) or a combination of at least two of these layers.

6. The solar cell (1) according to anyone of the preceding claims, wherein the surface on the front side (2a) of the substrate (2) has a texture with maxima and minima.

7. The solar cell (1) according to anyone of the proceeding claims, wherein the solar cell (1) comprises a first metal containing layer (7) being in an electrically conductive contact with the front side (2a) of the substrate (2) and a second metal containing layer (6) being in an electrically conductive contact with the conductive polymer layer (5) on the back side (2b) of the substrate (2).

8. The solar cells (1) according to claim 7, wherein the substrate (2) at the front side (2a) and beneath the at least one passivation layer (3) comprises an n-doped front surface field (n⁺-FSF) (2').

9. The solar cells (1) according to claim 7, wherein the passivation layer (3) is a layer of n-doped amorphous silicon (a-Si (n)) or a layer stack comprising an intrinsic undoped amorphous silicon layer (a-Si (i)) and Si n-doped amorphous silicon layer (a-Si (n)) and wherein the passivation layer (3) is covered with a layer of a transparent conductive coating.

10. The solar cell (1) according to anyone of claims 7 to 9, wherein the first metal containing layer (7) being in an electrically conductive contact with the front side (2a) of the substrate (2) is applied in the form of a metal grid or in the form of a pattern comprising at least one metal busbar and metal fingers.

11. The solar cell according to anyone of claims 1 to 6, wherein the solar cell (1) comprises a first metal containing layer (7) being in an electrically conductive contact with the back side (2b) of the substrate (2) and a second metal containing layer (6) being in an electrically conductive contact with the conductive polymer layer (5) on the back side (2b) of the substrate (2).

12. The solar cell (1) according to anyone of the preceding claims, wherein the conductive polymer layer (5) comprises, in addition to the conductive polymer, a polymeric anion, preferably a polymeric sulfonic acid or a polymeric carboxylic acid.

13. The solar cell (1) according to claim 12, wherein the conductive polymer comprises a polythiophene being present in the form of a polythiophene : polymeric anion complex, preferably PEDOT : PSS.

14. A process for the preperation of a solar cell (1) comprising the process steps:
I) providing a substrate (2) of p-type silicon or n-type silicon, wherein the substrate (2) comprises
- a front side (2a)
and
- a back side (2b);
II) covering at least a part of the surface of the substrate (2) on the back side (2b) with a passivation layer (4) having a thickness sufficient to allow a transport of holes through it;
III) covering at least a part of the surface of the passivation layer (4) on the backside (2b) of the substrate (2) with a conductive polymer layer (5); and
IV) covering at least a part of the surface of the conductive polymer layer (5) with a metal containing layer (6).

15. The process according to claim 14, wherein the passivation layer (4) on the backside (2b) of the substrate (2) comprises SiOₓ and has a thickness of less than 5 nm.

16. The process according to claim 15, wherein the passivation layer (4) comprising SiOₓ is formed by thermal oxidation of the surface of the substrate (2) on the back side (2b) with oxygen.

17. The process according to anyone of claims 14 to 16, wherein the conductive polymer layer is formed by applying a solution, emulsion or dispersion comprising a conductive polymer and a solvent or dispersant onto the passivation layer (4) and by subsequently removing at least a part of the solvent or dispersant.

18. The process according to claim 17, wherein the conductive polymer in the solution, emulsion or dispersion comprises a polythiophene.

19. The process according to claim 17 or 18, wherein the solution, emulsion or dispersion comprising a conductive polymer and a solvent or dispersant further comprises a polymeric anion, preferably a polymeric sulfonic acid or a polymeric carboxylic acid.

20. The process according to claim 19, wherein the conductive polymer comprises a polythiophene being present in the form of a polythiophene : polymeric anion complex, preferably PEDOT/PSS.

21. The process according to anyone of claims 14 to 20, wherein the substrate (2) is based on n-type monocrystalline silicon (c-Si).

22. The process according to anyone of claims 14 to 21, wherein the surface on the front side (2a) of the substrate (2) is at least partially covered with at least one passivation layer (3) selected from the group consisting of a silicon nitride layer (SiNₓ), a silicon oxide layer (SiOₓ), a silicon carbide layer (SiC), a titanium oxide layer (TiOₓ), an aluminium oxide layer (AlOₓ), a layer of amorphous silicon (a-Si) or a layer stack comprising of an intrinsic undoped amorphous silicon layer (a-Si (i)) and Si n-doped amorphous silicon layer (a-Si (n)) or a combination of at least two of these layers.

23. The process according to anyone of claims 14 to 22, wherein the surface on the front side (2a) of the substrate (2) has a texture with maxima and minima.

24. Solar cell (1), obtainable by the process according to anyone of claims 14 to 23.

25. A solar module, comprising at least two solar cells (1) according to anyone of claims 1 to 13 and 24.
